# EUROPÄISCHE PATENTSCHRIFT

(11) **EP 1 507 894 B1**
(45) Veröffentlichungstag und Bekanntmachung des Hinweises auf die Patenterteilung: **14.12.2005**
(21) Anmeldenummer: 03732467.0
(22) Anmeldetag: 26.05.2003
(51) Int. Cl.: C23C 16/54, C23C 16/04, C23C 16/458, C23C 14/50, C23C 14/04, C23C 14/56

(54) **BESCHICHTUNGSVORRICHTUNG MIT TRANSPORTEINRICHTUNG**
COATING DEVICE COMPRISING A CONVEYING DEVICE
DISPOSITIF D'APPLICATION DE REVETEMENT COMPORTANT UNE UNITE DE TRANSPORT

(30) Priorität: 24.05.2002 DE 10223288; 01.06.2002 DE 10224395; 20.06.2002 DE 10227637; 28.03.2003 DE 10314067
(43) Veröffentlichungstag der Anmeldung: 23.02.2005
(73) Patentinhaber: Schott AG, 55122 Mainz (DE)
(72) Erfinder: BEHLE, Stephan, 55239 Gau-Odernheim (DE); LÜTTRINGHAUS-HENKEL, Andreas, 64289 Darmstadt (DE); BAUCH, Hartmut, 61276 Weilrod (DE)
(74) Vertreter: Herden, Andreas F.
(86) Internationale Anmeldenummer: PCT/EP2003/005498
(87) Internationale Veröffentlichungsnummer: WO 2003/100128

(56) Entgegenhaltungen:
- WO-A-99/17334
- GB-A- 547 249
- US-A- 5 374 314

## Beschreibung

Die Erfindung betrifft allgemein das Beschichten von Substraten, insbesondere eine Vorrichtung und ein Verfahren zum Abscheiden von Funktionalschichten mittels einer Vorrichtung mit einer Transporteinrichtung für die zu beschichtenden Substrate.

Um die Barrierewirkungen insbesondere von Kunststoffbehältern wie etwa Kunststoffflaschen zu verbessern, können diese mit Barriereschichten versehen werden. Kunststoffbehälter, wie beispielsweise Plastikflaschen weisen oft eine für den gedachten Verwendungszweck nicht ausreichende Barrierewirkung für Gase auf. Beispielsweise können Gase wie Kohlendioxid aus Kunststoffflaschen hinaus- oder in diese hineindiffundieren. Dieser Effekt ist insbesondere bei der Aufbewahrung von Lebensmitteln zumeist unerwünscht, da dieser Effekt zu einer Verkürzung der Haltbarkeit von in diesen Behältern gelagerten Lebensmitteln führen kann. Mit Barrierebeschichtungen kann die Diffusion durch die Behälterwandungen um Größenordnungen reduziert werden.

Als besonders geeignet für das Aufbringen von Barrierebeschichtungen und anderen Funktionalschichten sind dabei verschiedene Dampfphasen-Abscheidungstechniken, wie physikalische oder chemische Dampfphasenabscheidung. Mit diesen Techniken ist es unter anderem möglich, sehr dichte und mit der Oberfläche des Werkstücks fest verbundene anorganische Schichten herzustellen, die eine gute Barrierewirkung besitzen.

Allerdings sind diese Verfahren vergleichsweise aufwendig, da die zu beschichtenden Substrate dazu in ein Vakuum gebracht und nach erfolgter Beschichtung wieder ausgeschleust werden müssen. Insbesondere für Beschichtungen im industriellen Maßstab ist dazu eine Maschine mit entsprechend hoher Leistung erforderlich. Hierzu sind beispielsweise Rundläufer- oder Langläufervorrichtungen geeignet, bei welchen kontinuierlich Substrate zugeführt, beschichtet und wieder entnommen werden. Problematisch ist hierbei unter anderem, wenn die abzuscheidenden Schichten lange Beschichtungszeiten erfordern. Beispielsweise können bestimmte Beschichtungen reine Beschichtungszeiten von länger als 20 Sekunden benötigen. In diesen Fällen ist eine kontinuierlich laufende Rundläufervorrichtung nicht mehr wirtschaftlich zu betreiben, da sie entweder entsprechend langsam laufen oder dessen Größe an die Prozeßzeiten angepaßt werden muß, was sehr große und entsprechend teure Maschinen erfordert.

Der Erfindung liegt daher die Aufgabe zugrunde, das Vakuumbeschichten von Substraten oder Werkstücken wirtschaftlicher zu machen.

Diese Aufgabe wird bereits in überraschend einfacher Weise durch eine Vorrichtung zur Beschichtung von Substraten gemäß Anspruch 1, sowie ein Verfahren zum Beschichten von Substraten gemäß Anspruch 23 gelöst. Vorteilhafte Weiterbildungen sind Gegenstand der jeweiligen Unteransprüche.

Dementsprechend sieht die Erfindung eine Vorrichtung zur Vakuumbeschichtung von Substraten vor, welche
- eine Transporteinrichtung,
- zumindest eine Beschichtungsstation oder Plasmastation mit mehreren Beschichtungsplätzen, die auf der Transporteinrichtung transportiert wird, und
- eine Einrichtung zum Evakuieren umfaßt. Außerdem weist die Vorrichtung eine Einrichtung zur Rotation der Beschichtungsplätze der Beschichtungsstation auf der Transporteinrichtung auf.
   Das erfindungsgemäße Verfahren zur Vakuumbeschichtung von Substraten, das insbesondere mittels einer erfindungsgemäßen Vorrichtung durchgeführt werden kann, umfaßt die Schritte
- Beladen einer Beschichtungsstation mit mehreren zu beschichtenden Substraten,
- Evakuieren der Beschichtungs- oder Plasmastation,
- Transportieren der Beschichtungsstation auf einer Transporteinrichtung,
- Vakuumbeschichten der Substrate,
- Belüften der Beschichtungsstation und
- Entnehmen der beschichteten Substrate, wobei die Beschichtungsplätze der Beschichtungsstation auf der Transporteinrichtung rotiert werden.

Als Transporteinrichtung ist für die erfindungsgemäße Vorrichtung, sowie das Verfahren zur Vakuumbeschichtung beispielsweise ein Transportkarussell oder eine lineare Transporteinrichtung, beziehungsweise ein Geradeausläufer geeignet. Bei der Ausführungsform der Erfindung mit Transportkarussell liegt dabei die Drehachse der Beschichtungsplätze bevorzugt parallel zur Drehachse des Transportkarussels oder Plasmarades.

Mittels einer Beschichtungsstation mit mehreren Beschichtungsplätzen wird der Beschichtungsvorgang für mehrere Substrate gleichzeitig durchgeführt. Dadurch kann bei gegebener Prozeßdauer der Durchsatz gegenüber einer Vorrichtung mit einzelnen Beschichtungsplätzen um einen Faktor erhöht werden, welcher der Anzahl der Beschichtungsplätze entspricht. Allerdings ergibt sich dabei das Problem der Zugänglichkeit zu allen Beschichtungsplätzen. Dies wird erfindungsgemäß dadurch gelöst, daß die Beschichtungsplätze rotiert werden und so jeder Beschichtungsplatz von einer Position aus zugänglich gemacht werden kann.

Bei dem erfindungsgemäßen Verfahren werden dabei die Beschichtungsplätze nicht unbedingt während des gesamten Verfahrensablaufs rotiert. Vielmehr kann dies bevorzugt während eines Prozeßschrittes geschehen, bei welchem die Beschichtungsplätze zugänglich gemacht werden sollen. Gemäß einer bevorzugten Ausführungsform der Erfindung wird eine Rotation insbesondere während des Beladevorgangs vorgenommen. Gemäß einer bevorzugten Ausführungsform der Erfindung werden dazu die Beschichtungsplätze mittels einer geeignet eingerichteten Einrichtung zur Rotation der Beschichtungsplätze zur Beladung mit Substraten so rotiert, daß die Beschichtungsplätze nacheinander in eine Beladeposition gebracht werden. Dies kann sowohl für jeden Beschichtungsplatz einzeln oder zusammengefaßt in Gruppen erfolgen.

In gleicher Weise kann auch das Entnehmen der beschichteten Substrate erleichtert werden, wenn die Beschichtungsplätze während des Entnahmevorgangs rotiert werden. Dazu kann die Beschichtungsstation zur Entnahme von Substraten von den Beschichtungsplätzen mittels einer geeignet eingerichteten Einrichtung zur Rotation der Beschichtungsplätze rotiert werden, so daß die Beschichtungsplätze nacheinander in eine Entnahmeposition gebracht werden.

Es ist nicht unbedingt erforderlich, zur Rotation der Beschichtungsplätze auf der Transporteinrichtung die gesamte Beschichtungsstation zu rotieren. Vielmehr kann die Beschichtungsstation vorteilhaft auch mit einem rotierbaren Substratträger ausgestattet sein. So kann die Beschichtungsstation feststehend auf der Transporteinrichung angebracht sein, wobei dann zur Rotation der Beschichtungsplätze der Substratträger rotiert wird.

Eine Weiterbildung dieser Ausführungsform sieht außerdem vor, daß der Substratträger Durchgangskanäle aufweist, welche eine den Beschichtungsplätzen zugewandte Seite des Trägers mit einer gegenüberliegenden Seite des Trägers verbindet. Die Beschichtungsstation kann außerdem eine Grundplatte mit Versorgungskanälen umfassen, welche zur Herstellung einer Verbindung zur Evakuierungseinrichtung und/oder zur Zuführung von Prozeßgas mit dem Substratträger zusammengeführt werden kann. Dabei können beispielsweise die Versorgungskanäle der Grundplatte mit den Durchgangskanälen des Substratträgers in verbunden werden. Die Versorgungskanäle dienen dabei vorzugsweise zur Evakuierung und Zuführung von Prozeßgas oder als Aussparung, um etwa eine Gaslanze einführen zu können.

In vorteilhafter Weiterbildung der erfindungsgemäßen Vorrichtung umfaßt diese außerdem eine geeignete Beladeeinrichtung und/oder Entnahmeeinrichtung zum Beladen und Entnehmen der Substrate. Sowohl das Beladen der Beschichtungsstation mit der Beladeeinrichtung, als auch die Entnahme mit der Entnahmeeinrichtung kann in einfacher Weise dabei über zumindest ein Zuteilrad erfolgen.

Gemäß einer besonders bevorzugten Ausführungsform der Erfindung umfaßt das Vakuumbeschichten das Plasmabeschichten oder plasmagestützte chemische Dampfphasenabscheidung der Substrate, die auch als PECVD (PECVD="Plasma Enhanced Chemical Vapor Deposition") bezeichnet wird. Dementsprechend umfaßt bei dieser Ausführungsform der Erfindung die Vorrichtung zur Vakuumbeschichtung von Substraten eine Einrichtung zur Plasmabeschichtung der Substrate. Vorteilhaft kann die Einrichtung zur Plasmabeschichtung auch eine Einrichtung zur Einleitung von Prozeßgas umfassen.

Die Plasmabeschichtung von Substraten ist beispielsweise gut geeignet, um auch nichtplanare, beziehungsweise stark gewölbte Oberflächen von Substraten zu beschichten, ohne, daß es zu Abschattungs- oder Einfallswinkeleffekten kommt. Für eine Plasmabeschichtung wird in einem Gas, welches die zu beschichtende Oberfläche umhüllt, ein Plasma gezündet. Aus den Reaktionsprodukten, die sich in dem Plasma bilden, scheidet sich dann eine Schicht auf der Oberfläche ab. Mittels dieses Verfahrens lassen sich verschiedenste Schichtzusammensetzungen durch geeignete Wahl der Zusammensezung des Prozeßgases erzeugen.

Bevorzugt wird dabei das Plasma durch Einwirkung elektromagnetischer Wellen, insbesondere von Mikrowellen auf das Prozeßgas erzeugt. Dazu umfaßt die Einrichtung zur Plasmabeschichtung eine Einrichtung zur Erzeugung elektromagnetischer Wellen, insbesondere zur Erzeugung von Mikrowellen. Diese werden den Beschichtungsplätzen zugeführt, wo es im Zusammenwirken mit vorhandenem Prozeßgas geeigneter Dichte zur Bildung eines Plasmas kommt.

Eine bevorzugte Variante dieser Ausführungsform der Erfindung sieht außerdem vor, die elektromagnetischen Wellen zu pulsen.

Diese Form der CVD-Beschichtung wird auch als Plasmaimpulsinduzierte chemische Dampfphasenabscheidung oder PICVD ("Plasma Impulse Chemical Vapor Deposition") bezeichnet. Beschichtung mittels eines gepulsten Plasmas ist unter anderem deshalb vorteilhaft, da sich die Wärmebelastung der Substrate entsprechend dem Tastverhältnis verringert. Auf diese Weise können auch sehr temperaturempfindliche Substrate, wie etwa Kunststoffflaschen plasmabeschichtet werden. Ein weiterer Vorteil dieser Variante der Plasmabeschichtung liegt darin, daß in den Pulspausen ein guter Austausch des Prozeßgases ermöglicht wird. Dadurch wird eine Anreicherung unerwünschter Reaktionsprodukte, die sich im Plasma bilden, vermieden.

Um einen hohen Durchsatz durch die erfindungsgemäße Vorrichtung zu erreichen und die Prozeßzeiten in der Vorrichtung gering zu halten, ist es außerdem vorteilhaft, die Beschichtungsstation möglichst schnell zu evakuieren. Dazu hat es sich als vorteilhaft erwiesen, das Evakuieren in mehreren Stufen durchzuführen. Die Einrichtung zum Evakuieren kann daher mit Vorteil mehrere Pumpstufen umfassen.

Weiterhin ist es von Vorteil, wenn die Einrichtung zum Evakuieren auch eine Einrichtung zum sequentiellen Verbinden der Beschichtungsstation mit mehreren Pumpstufen umfaßt, um eine schnelle Evakuierung zu erreichen. Die Pumpstufen können so beispielsweise jeweils in einem bestimmten Druckbereich arbeiten. Insbesondere können so mehrere Beschichtungsstationen gleichzeitig abgepumpt werden, wobei jede dieser Beschichtungsstationen mit einer Pumpstufe verbunden wird. Insbesondere kann diesbezüglich die erfindungsgemäße Vorrichtung besonders vorteilhaft ein Vakuumsystem aufweisen, wie es in der deutschen Anmeldung mit der Anmeldenummer 102 53 512.4 beschrieben wird, deren Offenbarung diesbezüglich vollumfänglich auch zum Gegenstand der vorliegenden Erfindung gemacht wird.

Weiterhin ist es möglich, gleichartige Pumpen zu verwenden und in Bewegungsrichtung aufeinanderfolgende Beschichtungsstationen abwechselnd mit den jeweiligen Pumpen zu verbinden.

Eine bevorzugte Ausführungsform der Erfindung sieht die Beschichtung hohlkörperförmiger Substrate, wie beispielsweise von Flaschen, Kalotten oder Ampullen vor. Dazu können die Beschichtungsplätze geeignete Aufnahmen für derartige hohlkörperförmige Substrate aufweisen. Diese Aufnahmen können auch bevorzugt so ausgebildet sein, daß sie eine Abdichtung des Innenraums der Substrate von der Umgebung der Substrate bereitstellen. Damit ist es dann beispielsweise möglich, den Innenraum der hohlkörperförmigen Substrate mit einer geeigneten Einrichtung separat zu evakuieren. Dies ist unter anderem dann von Vorteil, wenn nur eine Innen- oder Außenbeschichtung der Substrate vorgenommen werden soll. Wird beispielsweise eine Innenbeschichtung vorgenommen, so reicht es dann aus, den Außenbereich nur so weit abzupumpen, daß das Substrat der Druckdifferenz zwischen Innen- und Außenbereich widersteht.

Für viele Anwendungszwecke ist insbesondere eine Innenbeschichtung von hohlkörperförmigen Substraten zweckmäßig. So ist es beispielsweise für die Barrierewirkung erheblich besser, wenn eine Barrierebeschichtung auf der Innenseite der Substrate vorhanden ist. Um eine Innenbeschichtung vorzunehmen, ist dabei eine separate Zuführung von Prozeßgas in den Innenraum der Substrate mittels einer geeigneten Einrichtung vorteilhaft. Diese Einrichtung kann beispielsweise eine Gaslanze umfassen, welche in den Innenraum eingeführt wird und dort für eine gute und schnelle Verteilung des Prozeßgases sorgt. Ist der Innenraum mit Prozeßgas befüllt, so kann dann durch Einleitung von elektromagnetischen Wellen in die Beschichungsstation im Innenraum der Substrate ein Plasma gezündet werden, so daß eine Innenbeschichtung der Substrate erfolgt.

Gemäß einer weiteren vorteilhaften Weiterbildung der erfindungsgemäßen Vorrichtung weist die zumindest eine Beschichtungsstation mit mehreren Beschichtungsplätzen einem Reaktor mit einem beweglichen Hülsenteil, beziehungsweise einer beweglichen Kammerwandung und einem Substratträger oder Kammersockel auf, wobei in aneinandergefügter Position zumindest eine abgedichtete Beschichtungskammer oder Plasmakammer zwischen Hülsenteil und Substratträger definiert wird. Durch die bewegliche Ausgestaltung des Hülsenteils ist der Beschichtungsplatz in geöffneter Stellung der Beschichtungsstation besonders gut zugänglich, da die Substrate nicht in das Hülsenteil eingeführt werden müssen, sondern dieses beim Schließen der Beschichtungsstation über die Substrate gestülpt wird. Eine derartig ausgestaltete Beschichtungsstation wird auch in der deutschen Anmeldung mit der Anmeldenummer 102 53 512.2 beschrieben, deren Offenbarungsgehalt diesbezüglich vollumfänglich auch zum Gegenstand der vorliegenden Erfindung gemacht wird.

In vorteilhafter Weiterbildung der Erfindung kann das Öffnen und Schließen der Beschichtungsstation durch eine geeignete hydraulische, pneumatische oder elektrische Einrichtung erfolgen. Eine einfache Möglichkeit besteht auch darin, das Öffnen und Schließen durch Vorbeiführen der Beschichtungsstation an zumindest einer mechanischen Steuerkurve zu vermitteln.

Neben dem bevorzugten Plasmabeschichten können auch andere Beschichtungsverfahren, wie beispielsweise das PVD-Beschichten mittels einer entsprechenden Einrichtung in der erfindungsgemäßen Vorrichtung implementiert werden. Das PVD-Beschichten ist unter anderem dann vorteilhaft, wenn elektrisch leitende Schichten abgeschieden werden sollen.

Die Erfindung wird nachfolgend genauer anhand spezieller Ausführungsformen und unter Bezugnahme auf die beigefügten Zeichungen erläutert. Dabei verweisen gleiche Bezugszeichen auf gleiche oder ähnliche Teile.

Es zeigen:
- Fig. 1: eine schematische Aufsicht auf eine Ausführungsform einer erfindungsgemäßen Vorrichtung
- Fig. 2: einen Schnitt durch eine Ausführungsform einer Beschichtungsstation, und
- Fig. 3: eine Querschnittansicht durch eine Ausführungsform einer Beschichtungsstation mit Steuerung des Öffnungs- und Schließvorganges durch mechanische Steuerkurven.

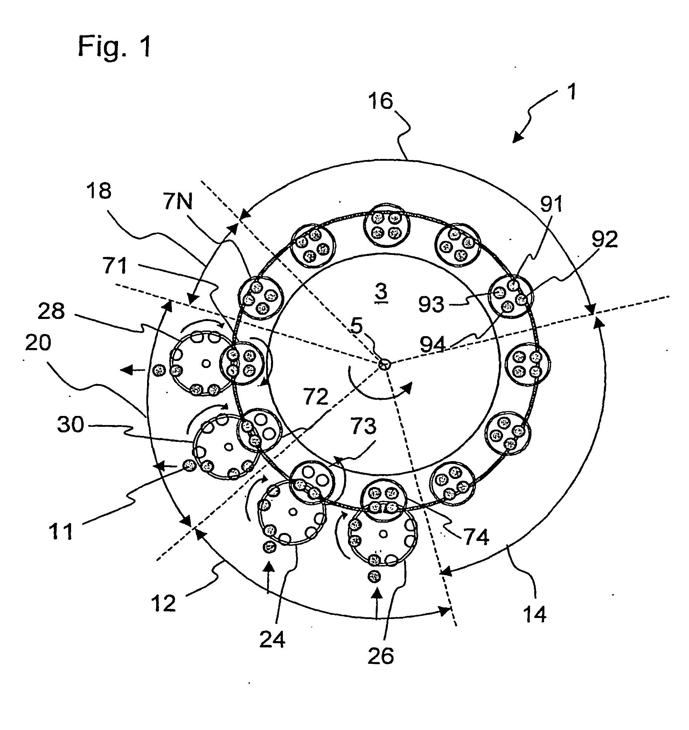

In Fig. 1 ist eine erste Ausführungsform einer erfindungsgemäßen Vorrichung zur Vakuumbeschichtung von Substraten dargestellt, die als Ganzes mit dem Bezugszeichen 1 bezeichnet ist.

Die Vorrichtung 1 umfaßt eine Transporteinrichtung mit einem Transportkarussell 3, welches um eine Drehachse 5 rotiert.

Auf dem Transportkarussell 3 sind eine Vielzahl von Beschichtungsstationen 71, 72, 73, 74, ... , 7N angeordnet, die mit der Transporteinrichtung transportiert werden.

Die Beschichtungsstationen 71, 72, 73, 74, ... , 7N weisen außerdem jeweils mehrere Beschichtungsplätze auf, wobei bei der in Fig. 1 dargestellten Ausführungsform beispielhaft jede Beschichtungsstation jeweils vier Beschichtungsplätze 91, 92, 93, 94 aufweist. Die Beschichtungsplätze einer Beschichtungsstation können mit einer Einrichtung zur Rotation der Beschichtungsplätze gegenüber der Transporteinrichtung rotiert werden, wie durch die Pfeile in Fig. 1 angedeutet ist. Bei dieser Ausführungsform der Erfindung liegt weiterhin die Drehachse der Beschichtungsplätze der Beschichtungsstationen parallel zur Drehachse 5 des Transportkarussells.

Das Beschichtungsverfahren wird durchgeführt, während das Transportkarussell 3 umläuft. Die verschiedenen Verfahrensschritte können so bestimmten Kreissektoren zugeordnet werden, die von den Beschichtungsplätzen 91, 92, 93, 94 der mit dem Karussell 3 transportierten Beschichtungsstationen 71, 72, ..., 7N beim Umlaufen des Karussells durchlaufen werden. Zunächst werden die Beschichtungsplätze der Beschichtungsstationen in einem ersten Kreissektor 12 beladen. Dies geschieht mittels einer Beladeeinrichung mit zwei Zuteilrädern oder Beladerädern 24 und 26. Zur Beladung der Beschichtungsplätze 91 - 94 werden diese durch Rotation auf der Transporteinrichtung nacheinander in eine Beladeposition gebracht, bei welcher die zu beladenden Beschichtungsplätze nach außen weisen. Bei dieser Ausführungsform der Erfindung werden dabei insbesondere die Beschichtungsplätze in zwei Gruppen mit jeweils zwei Beschichtungsplätzen nacheinander in eine Beladeposition gebracht und gemeinsam mit einem Zuteilrad 24, beziehungsweise 26 beladen.

Die Beschichtungsstationen werden ansschließend, nachdem die Beladung der Beschichtungsplätze abgeschlossen ist, durch einen Evakuierungssektor 14 transportiert, wo die Beschichtungsstationen bevorzugt in mehreren Stufen evakuiert werden. Dazu werden mehrere Pumpstufen, die in unterschiedlichen Druckbereichen arbeiten, nacheinander mit den Beschichtungsstationen 71, 72, ..., 7N verbunden.

Die Beschichtungsstationen durchlaufen anschließend einen Beschichtungssektor 16. Während des Durchlaufens dieses Sektors wird die Vakuumbeschichtung vorgenommen. Bevorzugt wird dabei eine Plasmabeschichtung durchgeführt, wobei ein Prozeßgas zugeführt und elektromagnetische Wellen zur Erzeugung eines Plasmas in den mit den Prozeßgas befüllten Bereichen eingestrahlt wird. Die Beschichtung erfolgt dabei besonders bevorzugt unter Verwendung eines gepulsten Plasmas, beziehungsweise gelpulster elektromagnetischer Wellen, um die Wärmebelastung der Substrate zu verringern und den Austausch von Prozeßgas in den Pulspausen zu verbessern.

Nach erfolgter Beschichtung werden die Beschichtungsstationen beim Durchlaufen eines Belüftungssektors 18 belüftet und geöffnet. Anschließend erfolgt die Entnahme der beschichteten Substrate 11 während des Durchlaufens eines Entnahmesektors 20 mittels einer Entnahmeeinrichtung mit Zuteilrädern oder Entladerädern 28, 30. Das Entnehmen der Substrate 11 von den Beschichtungsplätzen 91 bis 94 erfolgt in analoger Weise zum Beladevorgang. Auch hier werden nacheinander zwei Gruppen von Beschichtungsplätzen in eine auf dem Transportkarussell nach außen weisende Entnahmeposition gebracht und durch ein Zuteilrad 28, beziehungsweise 30 jeweils zwei Substrate einer Gruppe von zwei Beschichtungsplätzen entnommen. Das Bringen in die Entahmeposition erfolgt ebenfalls durch Rotation der Beschichtungsplätze gegenüber der Transporteinrichtung, beziehungsweise dem Transportkarussell 3.

Bei dieser Ausführungsform der Erfindung kann in einfacher Weise ein kontinuierlicher Umlauf der Beschichtungsstationen 71 - 7N auf der Transporteinrichtung realisiert werden, da das Beladen und Entnehmen jeweils über mehrere Zuteilräder erfolgt, an welchen die Beschichtungsstaationen vorbeigeführt werden. Selbstverständlich ist aber auch ein diskontinuierlicher Betrieb möglich, wobei der Umlauf des Transportkarussells 3 schrittweise erfolgt.

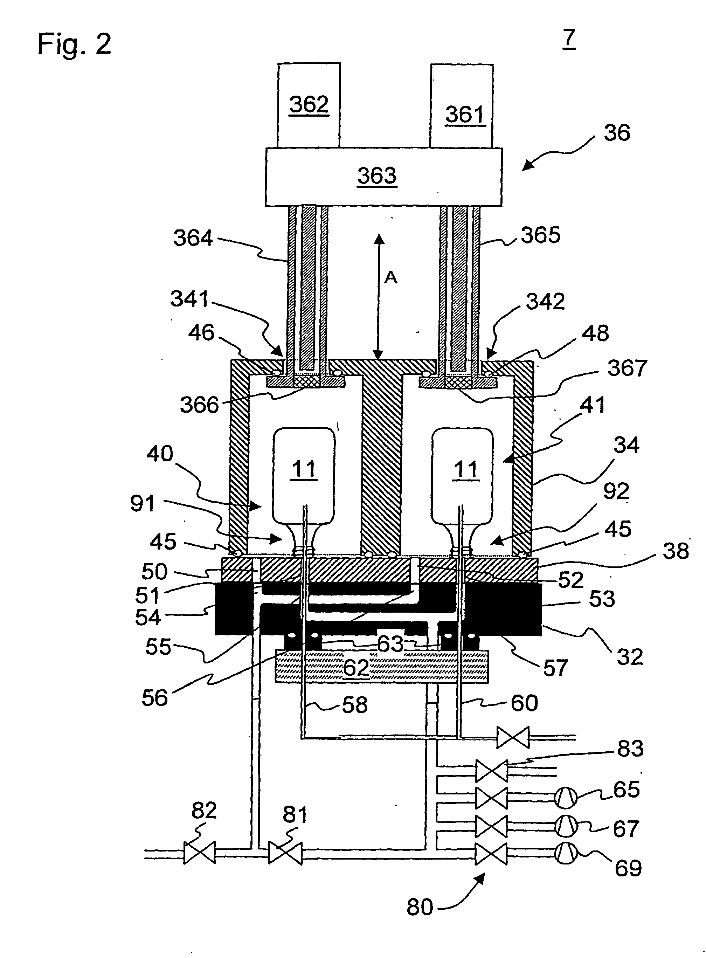

Fig. 2 zeigt einen Schnitt durch eine Ausführungsform einer Beschichtungsstation, die als Ganzes mit 7 bezeichnet ist. Die Beschichtungsstation 7 umfasst einen Reaktor mit einem beweglichen Hülsenteil 34 und einer Grundplatte oder Trägerplatte 32. Die Beschichtungsstation weist außerdem eine Einrichtung zur Rotation der Beschichtungsplätze auf der Transporteinrichtung mit einem Substrat- oder Werkstückträger 38, sowie eine Einrichtung zur Erzeugung elektromagnetischer Wellen 36 auf.

In aneinandergefügter Position, wie sie in Fig. 2 dargestellt ist, werden zwischen Hülsenteil 34 und Grundplatte 32 zwei abgedichtete Beschichtungskammern 40, 41 gebildet mit jeweils einem Beschichtungsplatz 91, beziehungsweise 92 für ein zu beschichtendes Substrat darstellen und in welche für die Beschichtung zum Zünden des Plasmas elektromagnetische Energie eingeleitet wird.

Dementsprechend können bei der in Fig. 2 gezeigten Ausführungsform zwei Substrate 11 gleichzeitig behandelt werden. Durch die Trennung der Kammern wird eine gegenseitige Beeinflussung der Plasmen während der Beschichtung vermieden.

Die Abdichtung der Beschichtungskammern 40, 41 der Beschichtungsstation 7 gegenüber der Umgebung wird dazu durch Dichtungen 45 hergestellt, welche zwischen Hülsenteil 34 und Substratträger 38 angeordnet sind.

Um Substrate 11, zu beschichten, werden diese auf dem Substratträger 38 angeordnet, das Hülsenteil 34 anschließend mit dem Substratträger 38 durch Bewegen des Hülsenteils 34 zusammengeführt, so daß in zusammengefügter Position beider Teile abgedichtete Beschichtungskammern 40, 41 zwischen Hülsenteil 34 und Substratträger 38 definiert werden, in welcher sich die Substrate 11 befinden, die Beschichtungskammern 40, 41 evakuiert, Prozeßgas eingeleitet, und schließlich ein Plasma durch Einleiten elektromagnetischer Energie erzeugt, so daß sich eine CVD-Beschichtung auf den an das Plasma angrenzenden Oberflächen der Werkstücke ausbildet.

Die Einrichtung 36 zur Erzeugung elektromagnetischer Wellen umfaßt in dieser Ausführungsform zwei Mikrowellenköpfe oder Mikrowellengeneratoren 361 und 362, einen Adapter in Form eines Rechteckhohlleiters 363 und zwei von diesem abzweigende Zuführungsleitungen oder Kopplungskanäle 364 und 365 auf, die bei der in Fig. 2 dargestellten Ausführungsform als Koaxialleiter ausgebildet sind. Die Mikrowellenköpfe erzeugen bevorzugt Mikrowellen mit der fernmeldetechnisch zugelassenen Frequenz 2,45 GHz.

Das Hülsenteil 34 wird bei der in Fig. 2 dargestellten Ausführungsform zum Öffnen und Verschließen der Beschichtungskammern 40, 41 im wesentlichen senkrecht zur Grundplatte 32 entlang der Richtung A bewegt. Die Richtung A verläuft dabei entlang der Zuführungsleiter 364 und 365, so dass das Hülsenteil 34 entlang der Zuführungsleiter beweglich ist. Die Leiter dienen dabei gleichzeitig als Führung für das Hülsenteil 34. Zum Öffnen und Schließen der Beschichtungskammern 40, 41 wird dementsprechend das Hülsenteil 34 bewegt, während der Substratträger 38 festgehalten wird.

Das Hülsenteil 34 weist ferner Öffnungen 341 und 342 auf, in welche die Zuführungsleiter 364 und 365 der Einrichtung zur Erzeugung elektromagnetischer Wellen eingreifen. Die Zuführungsleiter 364, 365 sind außerdem mit dielektrischen Fenstern 366, 367, wie beispielsweise Quarzglasfenster für die Einkopplung der Mikrowellen in den Niederdruck- oder Vakuumbereich des Reaktors 18 versehen.

Die Koaxialleiter, beziehungsweise Zuführungsleiter 364, 365 sind außerdem mit Dichtungskragen versehen, so daß beim Schließen der Beschichtungskammern 40, 41 durch Bewegen des Hülsenteils Dichtungen 46, 48 zwischen den Dichtungskragen und dem Hülsenteil 34 zusammengepresst werden und so eine vakuumdichte Abdichtung der Öffnungen 341, 342 schaffen.

Die in Fig. 2 gezeigte Ausführungsform einer Beschichtungsstation 7 ist speziell für die Beschichtung von hohlkörperförmigen Substraten 11, wie die in Fig. 2 beispielhaft dargestellten Kunststoffflaschen ausgebildet.

Der Substratträger 38 weist dazu Aufnahmen für die Flaschenhälse mit Dichtungen auf, welche das Innere der hohlkörperförmigen Substrate 11 gegenüber der Umgebung vakuumdicht abschließen. Damit können innen und außerhalb des Substrats unterschiedliche Drücke eingestellt werden, beispielsweise um eine reine Innenbeschichtung oder auch eine reine Außenbeschichtung oder unterschiedliche Beschichtungen im Innenraum und auf der Außenoberfläche der Substrate 11 herstellen zu können.

Zur Evakuierung und für die Zuführung von Prozessgas sind im Substratträger 38 Durchgangskanäle 50, 51, 52 und 53 vorhanden, welche die den Beschichtungsplätzen 91, 92 zugewandte Seite des Substratträgers mit der gegenüberliegenden Seite des Substratträgers 38 verbinden. Die Grundplatte 32 wird zur Zuführung von Prozessgas und zur Herstellung einer Verbindung zur Evakuierungseinrichtung mit dem Substratträger 38 zusammengeführt. Dazu weist die Grundplatte 32 außerdem Versorgungs- oder Kopplungskanäle 54, 55, 56, 57 auf. Die Durchgangskanäle 50 bis 54 und die Versorgungskanäle 54 bis 57 sind so angeordnet, dass die jeweils einander zugeordneten Versorgungskanäle und Durchgangskanäle zur Deckung gebracht und miteinander verbunden werden, wenn die Grundplatte 32 mit dem Substratträger 38 zusammengeführt wird. Damit wird unter anderem eine Verbindung zur Evakuierungseinrichtung geschaffen, so dassβ die Beschichtungskammern evakuiert und Prozessgas zugeführt werden kann. Dabei sind die Durchgangskanäle 50 bis 53 jeweils einem Versorgungskanal 54 bis 57 zugeordnet. Im einzelnen dienen dabei die Versorgungskanäle 54 und 56 der Vakuumversorgung der Umgebung der Substrate 11 in den Beschichtungskammern 40, 41 und die Versorgungskanäle 55 und 57 der Evakuierung des gegenüber der Umgebung abgedichteten Innenräume der Substrate 11. Außerdem dienen die Versorgungskanäle 55, 57 und die diesen zugeordneten Durchgangskanäle 51, 53 auch als Durchgangskanäle, durch welche Gaslanzen 58, 60 zur Zuführung von Prozessgas in die Innenräume der Substrate 11 eingeführt werden können. Die Gaslanzen 58, 60 sind an einer weiteren Trageplatte 62 mit Dichtungen 63 befestigt, welche nach dem Schließen der Beschichtungskammern mit der Grundplatte 32 zusammengeführt wird, so dass die Gaslanzen in die Innenräume der Substrate hineinragen und die Dichtungen 63 die Durchgangskanäle für die Gaslanzen nach außen hin abdichten.

Um den für die Beschichtung erforderlichen Druck in den Beschichtungskammer 40, 41 schnell erreichen zu können, ist eine mehrstufige Einrichtung zum Evakuieren mit mehreren Pumpstufen 65, 67, 69 vorgesehen. Weiterhin umfasst die Einrichtung zum Evakuieren eine Einrichtung zum sequentiellen Verbinden der zumindest einen Beschichtungsstation mit den mehreren Pumpstufen 65, 67, 69. Als Einrichtung zum sequentiellen Verbinden dienen dabei Ventile 80, mit denen nacheinander die vorgesehene Pumpstufe verbunden werden kann. Die Ventile 82, 83 dienen zur Belüftung der Beschichtungskammern, beziehungsweise als Kammerentlüftungsventile. Mit dem Ventil 81 kann eine Bypass-Leitung zu- oder abgeschaltet werden, welche die Versorgungskanäle 54, 56 zur Evakuierung der Umgebung der Substrate mit den Versorgungskanälen 55, 57 zur Evakuierung der Innenräume der Substrate 11 verbindet. Das Ventil 81 dient demgemäß als Kammervakuumventil. Durch Schließen des Ventil 81 kann so der Innenraum der Substrate 11 separat an die Pumpstufen angeschlossen werden, so dass das Ventil 81 als Einrichtung zum separaten Evakuieren des Innenraums der hohlkörperförmigen Substrate 11 dient.

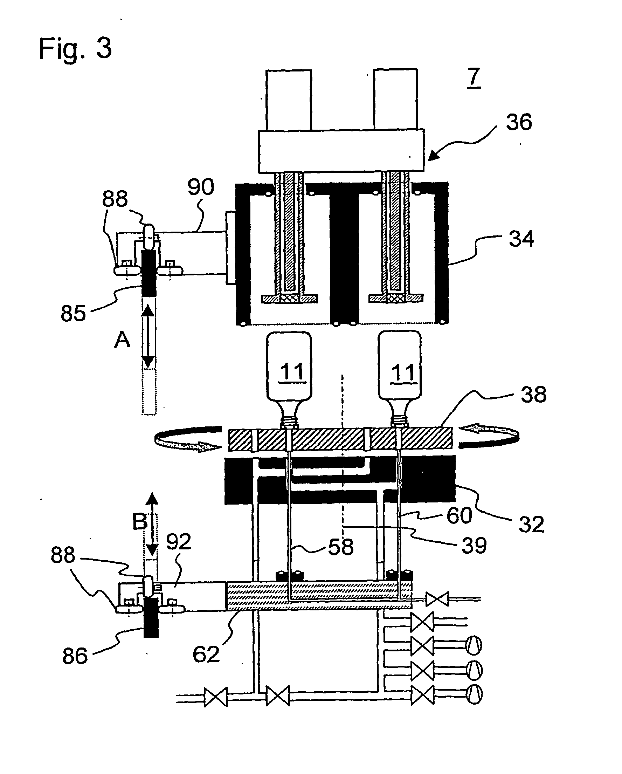

In Fig. 3 ist eine Querschnittansicht durch eine Ausführungsform einer Beschichtungsstation mit Steuerung des Öffnungs- und Schließvorganges durch mechanische Steuerkurven dargestellt. Die Beschichtungsstation 7 entspricht sonst im wesentlichen der anhand von Fig. 2 dargestellten Ausführungsform. Die Beschichtungsstation 7 ist außerdem in geöffnetem Zustand dargestellt, um den Belade- oder Entnahmevorgang zu illustrieren.

Der Substratträger 38 ist um eine Drehachse 39 mittels einer Einrichtung zur Rotation der Beschichtungsplätze 91 bis 94, von denen in Fig. 3 die Beschichtungsplätze 91 und 92 sichtbar sind, drehbar. Während des Beladevorgangs wird der Substratträger 38 mit den Beschichtungsplätzen 91 bis 94 rotiert, so dass die Beschichtungsplätze von einer Beladeposition aus zugänglich sind und die Substrate 11 werden in die Aufnahmen des Substratträgers 38 eingesetzt. Nachdem das Einsetzen der Substrate abgeschlossen ist, wird der Substratträger 38 so positioniert, dass dessen Durchgangskanäle mit den Versorgungskanälen der Grundplatte zur Deckung kommen und das Hülsenteil 34 wird mit dem Substratträger 38 zusammengeführt, so dass abgedichtete Beschichtungskammern definiert werden, die über die Versorgungskanäle in der Grundplatte 32 abgepumpt werden können. Anschließend werden die Gaslanzen 58, 60 in die Innenräume der Substrate 11 eingeführt. Sowohl das Bewegen des Hülsenteils, als auch das Einführen der Gaslanzen wird bei dieser Ausführungsform der Beschichtungsstation durch fest an der Vorrichtung angebrachte mechanische Steuerkurven 85, beziehungsweise 86 vermittelt. Dazu ist am Hülsenteil 34 und an der Trageplatte 62 Führungsarme 90, beziehungsweise 92 mit Führungsrollen 88 angebracht, welche die Steuerkurven 85, 86 umgreifen. Wird die Beschichtungsstation 7 auf der Transporteinrichtung bewegt, so folgen die Führungsarme 90, 92 dem Verlauf der mechanischen Steuerkurven, deren Querschnittsposition sich entlang der in Fig. 3 dargestellten Pfeile A, B ändert, so das eine Bewegung des Hülsenteils 34 in Richtung des Pfeils A, sowie eine Bewegung der Trageplatte 62 in Richtung des Pfeils B vermittelt wird.

### Bezugszeichenliste

- 1: Vorrichtung zur Vakuumbeschichtung von Substraten
- 3: Transportkarussell
- 5: Drehachse von 3
- 7, 71, 72, 73, 74,..., 7N: Beschichtungsstationen
- 91, 92, 93, 94,: Beschichtungsplätze
- 11: Substrat
- 12: Beladesektor
- 14: Evakuierungssektor
- 16: Beschichtungssektor
- 18: Belüftungssektor
- 20: Entnahmesektor
- 24, 26, 28, 30: Zuteilräder
- 32: Grundplatte
- 34: bewegliches Hülsenteil
- 341, 342: Öffnungen in 34
- 36: Einrichtung zur Erzeugung elektromagnetischer Wellen
- 361, 362: Mikrowellenkopf von 36
- 363: Rechteckhohlleiter von 36
- 364, 365: Zuführungsleitungen von 36
- 366, 367: dielektrische Fenster
- 38: Substratträger
- 39: Drehachse von 38
- 40, 41: Beschichtungskammern
- 45, 46, 48: Dichtungen
- 50, 51, 52, 53: Durchgangskanäle in 38
- 54, 55, 56, 57: Versorgungskanäle in 32
- 62: Trageplatte
- 63: Dichtungen von 62
- 65, 67, 69: Pumpstufen
- 80, 81, 83: Ventile
- 85, 86: mechanische Steuerkurve
- 88: Führungsrollen
- 90, 92: Führungsarm

## Patentansprüche

1. Vorrichtung (1) zur Vakuumbeschichtung von Substraten, welche
- eine Transporteinrichtung,
- zumindest eine Beschichtungsstation (7, 71, 72, ..., 7N) mit mehreren Beschichtungsplätzen (91 - 94), die auf der Transporteinrichtung transportiert wird, und
- eine Einrichtung zum Evakuieren umfasst, **gekennzeichnet durch** eine Einrichtung zur Rotation der Beschichtungsplätze (91 - 94) auf der Transporteinrichtung.

2. Vorrichtung gemäß Anspruch 1, **dadurch gekennzeichnet, dass** die Transporteinrichtung ein Transportkarussell (3) oder eine lineare Transporteinrichtung umfasst.

3. Vorrichtung gemäß Anspruch 2, bei welcher die Transporteinrichtung ein Transportkarussell (3) umfasst, **dadurch gekennzeichnet, dass** die Drehachse (39) der Beschichtungsplätze parallel zur Drehachse (5) des Transportkarussells (3) liegt.

4. Vorrichtung gemäß einem der vorstehenden Ansprüche, **dadurch gekennzeichnet, dass** die zumindest eine Beschichtungsstation (7, 71, 72, ..., 7N) einen rotierbaren Substratträger (38) umfasst.

5. Vorrichtung gemäß Anspruch 4, **dadurch gekennzeichnet, dass** der Substratträger (38) Durchgangskanäle (50 - 53) aufweist, welche eine den Beschichtungsplätzen (91 - 94) zugewandte Seite des Substratträgers (38) mit einer gegenüberliegenden Seite des Substratträgers (38) verbinden.

6. Vorrichtung gemäß Anspruch 4 oder 5, **dadurch gekennzeichnet, dass** die Beschichtungsstation (7, 71, 72, ..., 7N) eine Grundplatte (32) mit Versorgungskanälen (54 - 57) umfasst, welche zur Herstellung einer Verbindung zur Evakuierungseinrichtung oder zur Zuführung von Prozessgas mit dem Substratträger (38) zusammenführbar ist.

7. Vorrichtung gemäß einem der vorstehenden Ansprüche, **gekennzeichnet durch** eine Beladeinrichtung mit zumindest einem Zuteilrad (24, 26).

8. Vorrichtung gemäß einem der vorstehenden Ansprüche, **gekennzeichnet durch** eine Entnahmeeinrichtung mit zumindest einem Zuteilrad (28, 30).

9. Vorrichtung gemäß einem der vorstehenden Ansprüche, **dadurch gekennzeichnet, dass** die Einrichtung zur Rotation der Beschichtungsplätze (91 - 94) auf der Transporteinrichtung eingerichtet ist, zur Beladung der Beschichtungsplätze mit Substraten durch Rotation der Beschichtungsstation (7, 71, 72, ..., 7N) die Beschichtungsplätze nacheinander in eine Beladeposition zu bringen.

10. Vorrichtung gemäß einem der vorstehenden Ansprüche, **dadurch gekennzeichnet, daß** die Einrichtung zur Rotation der Beschichtungsstation (71, 72, ..., 7N) auf der Transporteinrichtung eingerichtet ist, zur Entnahme von Substraten von den Beschichtungsplätzen (91 - 94) durch Rotation der Beschichtungsstation (71, 72, ..., 7N) die Beschichtungsplätze (91 - 94) nacheinander in eine Entnahmeposition zu bringen.

11. Vorrichtung gemäß einem der vorstehenden Ansprüche, **gekennzeichnet durch** eine Einrichtung zur Plasmabeschichtung der Substrate (11).

12. Vorrichtung gemäß Anspruch 11, **dadurch gekennzeichnet, dass** die Einrichtung zur Plasmabeschichtung eine Einrichtung (36) zur Erzeugung elektromagnetischer Wellen, insbesondere zur Erzeugung von Mikrowellen umfasst.

13. Vorrichtung gemäß Anspruch 11 oder 12, **dadurch gekennzeichnet, dass** die Einrichtung zur Plasmabeschichtung eine Einrichtung zur Einleitung von Prozessgas umfasst.

14. Vorrichtung gemäß einem der vorstehenden Ansprüche, **dadurch gekennzeichnet, dass** die Einrichtung zum Evakuieren mehrere Pumpstufen (65, 67, 69) umfasst.

15. Vorrichtung gemäß einem der vorstehenden Ansprüche, **dadurch gekennzeichnet, dass** die Einrichtung zum Evakuieren eine Einrichtung zum sequentiellen Verbinden der zumindest einen Beschichtungsstation (7, 71, 72, ..., 7N) mit mehreren Pumpstufen (65, 67, 69) umfasst.

16. Vorrichtung gemäß einem der vorstehenden Ansprüche, **dadurch gekennzeichnet, dass** die Beschichtungsplätze (91 - 94) eine Aufnahme für hohlkörperförmige Substrate (11), insbesondere für Flaschen oder Ampullen aufweisen.

17. Vorrichtung gemäß Anspruch 16, **dadurch gekennzeichnet, dass** die Einrichtung zum Evakuieren eine Einrichtung zum separaten Evakuieren des Innenraums der hohlkörperförmigen Substrate (11) umfasst.

18. Vorrichtung gemäß Anspruch 16 oder 17, **gekennzeichnet durch** eine Einrichtung zur separaten Zuführung von Prozessgas in den Innenraum der hohlkörperförmigen Substrate (11).

19. Vorrichtung gemäß einem der vorstehenden Ansprüche, **dadurch gekennzeichnet, dass** die zumindest eine Beschichtungsstation (7, 71, 72, ..., 7N) mit mehreren Beschichtungsplätzen (91 - 94) einen Reaktor mit einem beweglichen Hülsenteil (34) und einem Substratträger (38) umfasst, wobei in aneinandergefügter Position zumindest eine abgedichtete Beschichtungskammer zwischen Hülsenteil und Substratträger (38) definiert wird.

20. Vorrichtung gemäß einem der vorstehenden Ansprüche, **gekennzeichnet durch** zumindest eine Hubeinrichtung zum Öffnen und Schließen der Beschichtungsstation (7, 71, 72,..., 7N), insbesondere eine pneumatische, hydraulische oder elektrische Hubeinrichtung.

21. Vorrichtung gemäß einem der vorstehenden Ansprüche, **gekennzeichnet durch** zumindest eine mechanische Steuerkurve (85) zum Öffnen und Schließen der Beschichtungsstation (7, 71, 72,..., 7N).

22. Vorrichtung gemäß einem der vorstehenden Ansprüche, **gekennzeichnet durch** eine Einrichtung zur PVD-Beschichtung der Substrate (11).

23. Verfahren zur Vakuumbeschichtung von Substraten (11), mittels einer Vorrichtung (1) insbesondere gemäß einem der vorstehenden Ansprüche, mit den Schritten
- Beladen einer Beschichtungsstation (7, 71, 72,..., 7N) mit mehreren zu beschichtenden Substraten (11),
- Evakuieren der Beschichtungsstation (7, 71, 72,..., 7N),
- Transportieren der Beschichtungsstation (7, 71, 72,..., 7N) auf einer Transporteinrichtung,
- Vakuumbeschichten der Substrate (11),
- Belüften der Beschichtungsstation (7, 71, 72,..., 7N) und
- Entnehmen der beschichteten Substrate (11), **dadurch gekennzeichnet, dass** die Beschichtungsplätze (91 - 94) auf der Transporteinrichtung rotiert werden.

24. Verfahren gemäß Anspruch 23, **dadurch gekennzeichnet, dass** die Beschichtungsstation (7, 71, 72, ..., 7N) auf einem Transportkarussell (3) oder einer linearen Transporteinrichtung transportiert wird.

25. Verfahren gemäß Anspruch 23 oder 24, wobei die Beschichtungsstation (7, 71, 72, ..., 7N) auf einem Transportkarussell (3) transportiert wird, **dadurch gekennzeichnet, dass** die Beschichtungsplätze (91 - 94) um eine Drehachse (39) rotiert werden, die parallel zur Drehachse (5) des Transportkarussells (3) liegt.

26. Verfahren gemäß einem der Ansprüche 23 bis 25, **dadurch gekennzeichnet, dass** das Beladen einer Beschichtungsstation (7, 71, 72, ..., 7N) mit mehreren zu beschichtenden Substraten (11) und/oder das Entnehmen der beschichteten Substrate (11) durch Zuteilräder (24, 26, 28, 30) erfolgt.

27. Verfahren gemäß einem der Ansprüche 23 bis 26, **dadurch gekennzeichnet, dass** die Beschichtungsplätze (91 - 94) zur Beladung mit Substraten (11) rotiert werden, so dass die Beschichtungsplätze (91 - 94) nacheinander in Beladepositionen gebracht werden.

28. Verfahren gemäß einem der Ansprüche 23 bis 27, **dadurch gekennzeichnet, dass** die Beschichtungsplätze (91 - 94) zur Entnahme von Substraten (11) rotiert werden, so dass die Beschichtungsplätze (91 - 94) nacheinander in Entnahmepositionen gebracht werden.

29. Verfahren gemäß einem der Ansprüche 23 bis 28, **dadurch gekennzeichnet, dass** das Rotieren der Beschichtungsplätze (91 - 94) das Rotieren eines Substratträgers (38) umfasst.

30. Verfahren gemäß Anspruch 29, **dadurch gekennzeichnet, dass** zur Herstellung einer Verbindung zur Evakuierungseinrichtung oder zur Zuführung von Prozessgas eine Grundplatte (32) mit Versorgungskanälen (53 - 57) mit dem Substratträger (38) zusammengeführt wird.

31. Verfahren gemäß Anspruch 30, wobei der Substratträger Durchgangskanäle (50 - 53) aufweist, welche eine den Beschichtungsplätzen (91 - 94) zugewandte Seite des Substratträgers (38) mit einer gegenüberliegenden Seite des Substratträgers (38) verbinden, und die beim Zusammenführen der Grundplatte (32) mit dem Substratträger (38) mit Versorgungskanälen (53 - 57) der Grundplatte (32) verbunden werden.

32. Verfahren gemäß einem der Ansprüche 23 bis 31, **dadurch gekennzeichnet, dass** das Vakuumbeschichten der Substrate (11) das Plasmabeschichten umfasst.

33. Verfahren gemäß Anspruch 32, **dadurch gekennzeichnet, dass** zur Erzeugung eines Plasmas den Beschichtungsplätzen elektromagnetische Wellen, insbesondere Mikrowellen zugeführt werden.

34. Verfahren gemäß Anspruch 33, **dadurch gekennzeichnet, dass** die elektromagnetischen Wellen gepulst werden.

35. Verfahren gemäß einem der Ansprüche 23 bis 34, **dadurch gekennzeichnet, dass** das Evakuieren in mehreren Stufen erfolgt.

36. Verfahren gemäß einem der Ansprüche 23 bis 35, zur Beschichtung hohlkörperförmiger Substrate (11), **dadurch gekennzeichnet, dass** der Innenraum der hohlkörperförmigen Substrate separat evakuiert wird.

37. Verfahren gemäß einem der Ansprüche 23 bis 36, zur Beschichtung hohlkörperförmiger Substrate (11), **dadurch gekennzeichnet, dass** in den Innenraum der hohlkörperförmigen Substrate (11) separat Prozessgas zugeführt wird.

38. Verfahren gemäß Anspruch 37, **dadurch gekennzeichnet, dass** durch Einleitung von elektromagnetischen Wellen in die Beschichungsstation im Innenraum der Substrate (11) ein Plasma gezündet wird und eine Innenbeschichtung der Substrate (11) erfolgt.

39. Verfahren gemäß einem der Ansprüche 23 bis 38, **dadurch gekennzeichnet, dass** das Vakuumbeschichten das PVD-Beschichten der Substrate (11) umfasst.

## Claims

1. Device (1) for vacuum coating of substrates which comprises
- a transport device,
- at least one coating station (7, 71, 72, ..., 7N) with a plurality of coating positions (91 - 94) which are transported on the transport device, and
- a device for evacuation,
**characterised by** a device for rotating the coating positions (91 - 94) on the transport device.

2. Device according to claim 1, **characterised in that** the transport device comprises a transport carousel (3) or a linear transport device.

3. Device according to claim 2 wherein the transport device comprises a transport carousel (3), **characterised in that** the rotation axis (39) of the coating positions lies parallel to the rotation axis (5) of the transport carousel (3).

4. Device according to one of the preceding claims, **characterised in that** the at least one coating station (7, 71, 72, ..., 7N) comprises a rotatable substrate carrier (38).

5. Device according to claim 4, **characterised in that** the substrate carrier (38) comprises through channels (50 - 53) which connect a side of the substrate carrier (38) facing the coating positions (91 - 94) to an opposite side of the substrate carrier (38).

6. Device according to claim 4 or 5, **characterised in that** the coating station (7, 71, 72, ..., 7N) comprises a base plate (32) with supply channels (54 - 57) which can be brought together with the substrate carrier (38) for the purpose of producing a connection to the evacuating device or for the purpose of supplying process gas.

7. Device according to one of the preceding claims, **characterised by** a loading device with at least one distributing wheel (24, 26).

8. Device according to one of the preceding claims, **characterised by** a removal device with at least one distributing wheel (28, 30).

9. Device according to one of the preceding claims, **characterised in that** the device for rotation of the coating positions (91 - 94) is arranged on the transport device in order, for the purpose of loading the coating positions with substrates, to bring the coating positions one after the other into a loading position through rotation of the coating station (7, 71, 72, ..., 7N),

10. Device according to one of the preceding claims, **characterised in that** the device for rotation of the coating station (71, 72, ..., 7N) is arranged on the transport device in order, for the purpose of removal of substrates from the coating positions (91 - 94), to bring the coating positions (91 - 94) one after the other into a removal position through rotation of the coating station (71, 72, ..., 7N)

11. Device according to one of the preceding claims, **characterised by** a device for plasma coating of the substrates (11).

12. Device according to claim 11, **characterised in that** the device for plasma coating comprises a device (36) for producing electromagnetic waves, in particular for producing microwaves.

13. Device according to claim 11 or 12, **characterised in that** the device for plasma coating comprises a device for introducing process gas.

14. Device according to one of the preceding claims, **characterised in that** the device for evacuation has a plurality of pump stages (65, 67, 69).

15. Device according to one of the preceding claims, **characterised in that** the device for evacuation comprises a device for sequential connection of the at least one coating station (7, 71, 72, ..., 7N) with a plurality of pump stages (65, 67, 69).

16. Device according to one of the preceding claims, **characterised in that** the coating positions (91 - 94) comprise a receiving area for substrates (11) in the form of hollow bodies, in particular for bottles or ampoules.

17. Device according to claim 16, **characterised in that** the device for evacuation comprises a device for the separate evacuation of the inner area of the substrates (11) in the form of hollow bodies.

18. Device according to claim 16 or 17, **characterised by** a device for the separate supply of process gas into the inner area of the substrates (11) in the form of hollow bodies.

19. Device according to one of the preceding claims, **characterised in that** the at least one coating station (7, 71, 72, ..., 7N) with a plurality of coating positions (91 - 94) comprises a reactor with a movable sleeve part (34) and a substrate carrier (38) wherein in the joined-together position at least one sealed coating chamber is defined between the sleeve part and the substrate carrier (38).

20. Device according to one of the preceding claims, **characterised by** at least one displacement device for the opening and closing of the coating station (7, 71, 72, ..., 7N), in particular a pneumatic, hydraulic or electrical displacement device.

21. Device according to one of the preceding claims, **characterised by** at least one mechanical operating cam (85) for opening and closing the coating station (7, 71, 72, ..., 7N).

22. Device according to one of the preceding claims, **characterised by** a device for PVD coating of the substrates (11).

23. Method for vacuum coating of substrates (11) by means of a device (1) particularly according to one of the preceding claims, with the steps
- loading of a coating station (7, 71, 72, ..., 7N) with a plurality of substrates (11) to be coated,
- evacuation of the coating station (7, 71, 72, ..., 7N),
- transporting of the coating station (7, 71, 72, ..., 7N) on a transport device,
- vacuum coating of the substrates (11),
- ventilation of the coating station (7, 71, 72, ..., 7N) and
- removal of the coated substrates (11),
**characterised in that** the coating positions (91 - 94) are rotated on the transport device.

24. Method according to claim 23, **characterised in that** the coating station (7, 71, 72, ..., 7N) is transported on a transport carousel (3) or a linear transport device.

25. Method according to claim 23 or 24 wherein the coating station (7, 71, 72, ..., 7N) is transported on a transport carousel (3), **characterised in that** the coating positions (91 - 94) are rotated about a rotation axis (39) which lies parallel to the rotation axis (5) of the transport carousel (3).

26. Method according to one of the claims 23 to 25, **characterised in that** the loading of a coating station (7, 71, 72, ..., 7N) with a plurality of substrates (11) to be coated and / or the removal of the coated substrates (11) is carried out through distributing wheels (24, 26, 28, 30).

27. Method according to one of the claims 23 to 26, **characterised in that** the coating positions (91 - 94) are rotated for the purpose of loading with substrates (11) in such a way that the coating positions (91 - 94) are brought one after the other into loading positions.

28. Method according to one of the claims 23 to 27, **characterised in that** the coating positions (91 - 94) are rotated for the removal of substrates (11) in such a way that the coating positions (91 - 94) are brought one after the other into the removal position.

29. Method according to one of the claims 23 to 28, **characterised in that** the rotation of the coating positions (91 - 94) incorporates the rotation of a substrate carrier (38).

30. Method according to claim 29, **characterised in that** a base plate (32) with supply channels (53 - 57) is brought together with the substrate carrier (38) for the purpose of producing a connection with the evacuation device or for the purpose of supplying process gas.

31. Method according to claim 30 wherein the substrate carrier comprises through channels (50 - 53) which connect a side of the substrate carrier (38) facing the coating positions (91 - 94) to an opposite side of the substrate carrier (38) and which, when the base plate (32) is brought together with the substrate carrier (38), are connected to supply channels (53 - 57) of the base plate (32).

32. Method according to one of the claims 23 to 31, **characterised in that** the vacuum coating of the substrates (11) comprises plasma coating.

33. Method according to claim 32, **characterised in that** electromagnetic waves, in particular microwaves, are supplied to the coating positions for the purpose of producing a plasma.

34. Method according to claim 33, **characterised in that** the electromagnetic waves are pulsed.

35. Method according to one of the claims 23 to 34, **characterised in that** the evacuation takes place in several stages.

36. Method according to one of the claims 23 to 35 for the coating of substrates (11) in the form of hollow bodies, **characterised in that** the inner area of the substrates in the form of hollow bodies is separately evacuated.

37. Method according to one of the claims 23 to 36 for the coating of substrates (11) in the form of hollow bodies, **characterised in that** process gas is separately supplied into the inner area of the substrates (11) in the form of hollow bodies.

38. Method according to claim 37, **characterised in that** through the introduction of electromagnetic waves into the coating station a plasma is ignited in the inner area of the substrates (11) and an inner coating of the substrates (11) takes place.

39. Method according to one of the claims 23 to 38, **characterised in that** the vacuum coating comprises PVD coating of the substrates (11).

## Revendications

1. Dispositif (1) d'application de revêtement sous vide de substrats, lequel comporte
- une unité de transport,
- au moins un poste d'application de revêtement (7, 71, 72, ..., 7N) doté de plusieurs points d'application de revêtement (91 à 94), qui est transporté sur l'unité de transport, et
- une unité de production de vide,
**caractérisé par** une unité de rotation des points d'application de revêtement (91 à 94) sur l'unité de transport.

2. Dispositif selon la revendication 1, **caractérisé en ce que** l'unité de transport comporte un carrousel de transport (3) ou une unité de transport linéaire.

3. Dispositif selon la revendication 2, dans lequel l'unité de transport comporte un carrousel de transport (3), **caractérisé en ce que** l'axe de rotation (39) des points d'application de revêtement se situe parallèlement à l'axe de rotation (5) du carrousel de transport (3).

4. Dispositif selon l'une des revendications précédentes, **caractérisé en ce qu'**au moins un poste d'application de revêtement (7, 71, 72, ..., 7N) comporte un support de substrat rotatif (38).

5. Dispositif selon la revendication 4, **caractérisé en ce que** le support de substrat (38) comprend des canaux de passage (50 à 53), lesquels relient un côté du support de substrat (38) tourné vers les points d'application de revêtement (91 à 94) à un côté opposé du support de substrat (38).

6. Dispositif selon la revendication 4 ou 5, **caractérisé en ce que** le poste d'application de revêtement (7, 71, 72, ..., 7N) comporte une plaque de base (32) dotée de canaux d'alimentation (54 à 57), laquelle, pour créer une liaison à l'unité de production de vide ou pour amener le gaz de traitement, peut être assemblée au support de substrat (38).

7. Dispositif selon l'une des revendications précédentes, **caractérisé par** une unité de chargement dotée d'au moins une roue de distribution (24, 26).

8. Dispositif selon l'une des revendications précédentes, **caractérisé par** une unité de prélèvement dotée d'au moins une roue de distribution (28, 30).

9. Dispositif selon l'une des revendications précédentes, **caractérisé en ce que** l'unité de rotation des points d'application de revêtement (91 à 94) sur l'unité de transport est réglée, en vue du chargement des points d'application de revêtement en substrats par la rotation du poste d'application de revêtement (7, 71, 72, ..., 7N), pour amener successivement les points d'application de revêtement dans une position de chargement.

10. Dispositif selon l'une des revendications précédentes, **caractérisé en ce que** l'unité de rotation du poste d'application de revêtement (71, 72, ..., 7N) sur l'unité de transport est réglée, en vue du prélèvement des substrats des points d'application de revêtement (91 à 94) par la rotation du poste d'application de revêtement (71, 72, ..., 7N), pour amener successivement les points d'application de revêtement (91 à 94) dans une position de prélèvement.

11. Dispositif selon l'une des revendications précédentes, **caractérisé par** une unité destinée à l'application de revêtement au plasma sur les substrats (11).

12. Dispositif selon la revendication 11, **caractérisé en ce que** l'unité destinée à l'application de revêtement au plasma comporte une unité (36) de génération d'ondes électromagnétiques, destinée notamment à générer des micro-ondes.

13. Dispositif selon la revendication 11 ou 12, **caractérisé en ce que** l'unité destinée à l'application de revêtement au plasma comporte une unité d'introduction d'un gaz de traitement.

14. Dispositif selon l'une des revendications précédentes, **caractérisé en ce que** l'unité de production de vide comporte plusieurs étapes de pompage (65, 67, 69).

15. Dispositif selon l'une des revendications précédentes, **caractérisé en ce que** l'unité de production de vide comporte une unité destinée à la liaison séquentielle d'au moins un poste d'application de revêtement (7, 71, 72, ..., 7N) à plusieurs étapes de pompage (65, 67, 69).

16. Dispositif selon l'une des revendications précédentes, **caractérisé en ce que** les points d'application de revêtement (91 à 94) comprennent une réception pour des substrats (11) en forme de corps creux, notamment pour des bouteilles ou des ampoules.

17. Dispositif selon la revendication 16, **caractérisé en ce que** l'unité de production de vide comporte une unité de production de vide, de façon séparée, à l'intérieur des substrats (11) en forme de corps creux.

18. Dispositif selon la revendication 16 ou 17, **caractérisé par** une unité d'amenée séparée du gaz de traitement à l'intérieur des substrats (11) en forme de corps creux.

19. Dispositif selon l'une des revendications précédentes, **caractérisé en ce qu'**au moins un poste d'application de revêtement (7, 71, 72, ..., 7N) doté de plusieurs points d'application de revêtement (91 à 94) comporte un réacteur doté d'une partie de manchon mobile (34) et d'un support de substrat (38), au moins une chambre d'application de revêtement étanchéifiée, dans la position assemblée, étant définie entre la partie de manchon et le support de substrat (38).

20. Dispositif selon l'une des revendications précédentes, **caractérisé par** au moins une unité de levage destinée à ouvrir et à fermer le poste d'application de revêtement (7, 71, 72, ..., 7N), notamment une unité de levage pneumatique, hydraulique ou électrique.

21. Dispositif selon l'une des revendications précédentes, **caractérisé par** au moins une came de commande mécanique (85) destinée à ouvrir et à fermer le poste d'application de revêtement (7, 71, 72, ..., 7N).

22. Dispositif selon l'une des revendications précédentes, **caractérisé par** une unité d'application de revêtement en phase vapeur sur les substrats (11).

23. Procédé d'application de revêtement sous vide de substrats (11) au moyen d'un dispositif (1), notamment selon l'une des revendications précédentes, comprenant les étapes de
- chargement d'un poste d'application de revêtement (7, 71, 72, ..., 7N) en plusieurs substrats (11) destinés à être revêtus,
- production de vide dans le poste d'application de revêtement (7, 71, 72, ..., 7N),
- transport du poste d'application de revêtement (7, 71, 72, ..., 7N) sur une unité de transport,
- application de revêtement sous vide sur des substrats (11),
- ventilation du poste d'application de revêtement (7, 71, 72, ..., 7N) et
- prélèvement des substrats (11) revêtus, **caractérisé en ce que** les points d'application de revêtement (91 à 94) sur l'unité de transport sont amenés en rotation.

24. Procédé selon la revendication 23, **caractérisé en ce que** le poste d'application de revêtement (7, 71, 72, ..., 7N) est transporté sur un carrousel de transport (3) ou une unité de transport linéaire.

25. Procédé selon la revendication 23 ou 24, le poste d'application de revêtement (7, 71, 72, ..., 7N) étant transporté sur un carrousel de transport (3), **caractérisé en ce que** les points d'application de revêtement (91 à 94) sont amenés en rotation autour d'un axe de rotation (39) qui se situe parallèlement à l'axe de rotation (5) du carrousel de transport (3).

26. Procédé selon l'une des revendications 23 à 25, **caractérisé en ce que** le chargement d'un poste d'application de revêtement (7, 71, 72, ..., 7N) en plusieurs substrats (11) destinés à être revêtus et/ou le prélèvement des substrats revêtus (11) s'effectuent par des roues de distribution (24, 26, 28, 30).

27. Procédé selon l'une des revendications 23 à 26, **caractérisé en ce que** les points d'application de revêtement (91 à 94), en vue du chargement en substrats (11), sont amenés en rotation, de sorte que les points d'application de revêtement (91 à 94) sont amenés successivement dans des positions de chargement.

28. Procédé selon l'une des revendications 23 à 27, **caractérisé en ce que** les points d'application de revêtement (91 à 94), en vue du prélèvement des substrats (11), sont amenés en rotation, de sorte que les points d'application de revêtement (91 à 94) sont amenés successivement dans des positions de prélèvement.

29. Procédé selon l'une des revendications 23 à 28, **caractérisé en ce que** la rotation des points d'application de revêtement (91 à 94) comporte la rotation d'un support de substrat (38).

30. Procédé selon la revendication 29, **caractérisé en ce que**, pour créer une liaison à l'unité de production de vide ou pour amener le gaz de traitement, une plaque de base (32) dotée de canaux d'alimentation (53 à 57) est assemblée au support de substrat (38).

31. Procédé selon la revendication 30, le support de substrat comprenant des canaux de passage (50 à 53), lesquels relient un côté du support de substrat (38) tourné vers les points d'application de revêtement (91 à 94) à un côté opposé du support de substrat (38), et qui, lorsque la plaque de base (32) est assemblée au support de substrat (38), sont reliés aux canaux d'alimentation (53 à 57) de la plaque de base (32).

32. Procédé selon l'une des revendications 23 à 31, **caractérisé en ce que** l'application de revêtement sous vide des substrats (11) comporte l'application de revêtement au plasma.

33. Procédé selon la revendication 32, **caractérisé en ce que**, pour générer un plasma, des ondes électromagnétiques, notamment des micro-ondes, sont amenées aux points d'application de revêtement.

34. Procédé selon la revendication 33, **caractérisé en ce que** les ondes électromagnétiques sont pulsées.

35. Procédé selon l'une des revendications 23 à 24, **caractérisé en ce que** la production de vide s'effectue en plusieurs étapes.

36. Procédé selon l'une des revendications 23 à 35, pour l'application de revêtement sur des substrats (11) en forme de corps creux, **caractérisé en ce qu'**un vide est produit à l'intérieur des substrats en forme de corps creux de façon séparée.

37. Procédé selon l'une des revendications 23 à 36, pour l'application de revêtement sur des substrats (11) en forme de corps creux, **caractérisé en ce qu'**un gaz de traitement est amené de façon séparée à l'intérieur des substrats (11) en forme de corps creux.

38. Procédé selon la revendication 37, **caractérisé en ce qu'**en introduisant des ondes électromagnétiques dans le poste d'application de revêtement à l'intérieur des substrats (11), un plasma est amorcé et une application de revêtement interne est effectuée sur les substrats (11).

39. Procédé selon l'une des revendications 23 à 38, **caractérisé en ce que** l'application de revêtement sous vide comporte l'application d'un revêtement en phase vapeur sur les substrats (11).
